(19) **Europäisches Patentamt**

**European Patent Office**

**Office européen des brevets**

(11) **EP 1 406 379 A1**

(12) **DEMANDE DE BREVET EUROPEEN**

(43) Date de publication:
**07.04.2004 Bulletin 2004/15**

(51) Int Cl.⁷: **H03B 5/12**

(21) Numéro de dépôt: **03292240.3**

(22) Date de dépôt: **11.09.2003**

(84) Etats contractants désignés:
**AT BE BG CH CY CZ DE DK EE ES FI FR GB GR
HU IE IT LI LU MC NL PT RO SE SI SK TR**
Etats d'extension désignés:
**AL LT LV MK**

(30) Priorité: **26.09.2002 FR 0211933**

(71) Demandeur: **Stmicroelectronics SA
F-92120 Montrouge (FR)**

(72) Inventeurs:
• **Divel, Theirry
  38760 Varces (FR)**
• **Mira, Julien
  38000 Grenoble (FR)**

(74) Mandataire: **Bentz, Jean-Paul
Novagraaf Technologies SA
122, rue Edouard Vaillant
92593 Levallois-Perret Cedex (FR)**

(54) **Oscillateur à varactors commandé en tension, à étalement de sensibilité**

(57) L'invention concerne un oscillateur commandé en tension comprenant un résonateur à circuit inductif et à circuit capacitif dont les oscillations sont entretenues par un circuit actif, le circuit capacitif (CAPA) utilisant des varactors dont la capacité est ajustée par une tension de commande (Vcom) agissant en mode différentiel avec une tension de polarisation.

Selon l'invention, le circuit capacitif (CAPA) comprend plusieurs branches capacitives (B1, B2, B3) montées en parallèle, commandées par la même tension de commande (Vcom), mais polarisées par des tensions de polarisation (Vpol1, Vpol2, Vpol3) différentes d'une branche à l'autre.

L'oscillateur de l'invention présente notamment une fréquence d'oscillation beaucoup plus facile à contrôler et un bruit de phase considérablement réduit.

**Fig. 5**

## Description

L'invention concerne, de façon générale, la conception de circuits électroniques.

Plus précisément, l'invention concerne un oscillateur commandé en tension, comprenant un circuit oscillant et un circuit actif, le circuit oscillant comprenant lui-même un circuit inductif et un circuit capacitif partageant des première et seconde bornes principales auxquelles le circuit actif est relié pour entretenir un transfert oscillant d'énergie électrique entre les circuits inductif et capacitif à une fréquence. dépendant de la capacité du circuit capacitif, cette capacité variant en fonction d'une différence de potentiel réglable formée par différence entre une tension de polarisation et une tension de commande réglable, le circuit capacitif comprenant une première branche du type de celles dont chacune comprend des éléments capacitifs à capacité variable montés en série entre les première et seconde bornes principales et répartis sur des première et seconde moitiés de cette branche, symétriques l'une de l'autre par rapport à une borne centrale sur laquelle est appliquée la tension de commande, ces première et seconde moitiés de branche présentant respectivement des première et seconde bornes extrêmes portées à des premier et second potentiels respectifs, respectivement proportionnels aux potentiels des première et seconde bornes principales et décalés par la tension de polarisation.

Un oscillateur électrique est un dispositif connu de l'homme de métier pour produire un signal électrique à une fréquence F définie par une constante de temps qui lui est propre.

Par exemple, un oscillateur constitué par un circuit résonant passif formé d'un circuit inductif d'inductance L et d'un circuit capacitif de capacité C montés en parallèle, et par un amplificateur, c'est-à-dire un circuit actif, propre à compenser les pertes électriques dans le circuit résonant, produit un signal électrique dont la fréquence F est donnée par $1 / 2\Pi . (L.C)^{\frac{1}{2}}$.

Pour faire varier la fréquence de résonance F, et comme le laisse prévoir cette formule, il est également connu. de faire varier soit l'inductance L du circuit inductif, soit la capacité C du circuit capacitif.

Une solution communément employée dans ce dernier cas consiste à utiliser des composants actifs, appelés varactors, qui présentent une capacité variable en fonction d'une tension de commande qui leur est appliquée, et qui permettent ainsi la réalisation d'oscillateurs commandés en tension.

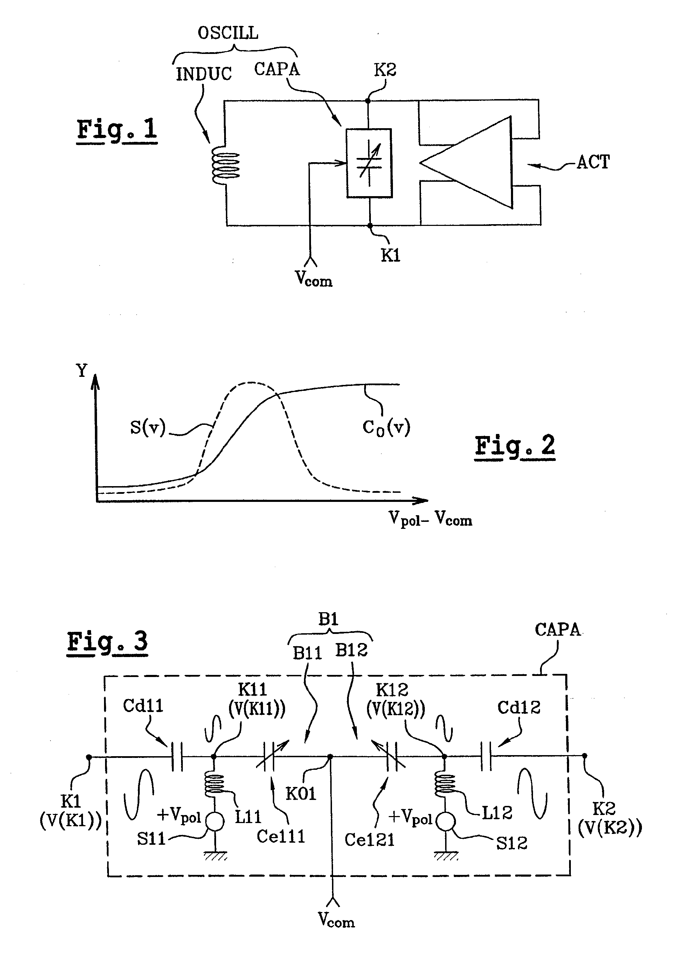

La figure 1 illustre ce type d'oscillateurs, auquel appartient l'oscillateur de l'invention.

Si F est la fréquence d'oscillation d'un tel oscillateur, et Vcom sa tension de commande, cet oscillateur peut être caractérisé par un gain de transfert G(V) défini par :

$G(V) = dF / dVcom$.

Par définition, le gain de transfert G(V), qui constitue une caractéristique fondamentale de l'oscillateur, est directement lié à la plage de variation du varactor.

Le problème est que si ce gain est trop important, l'oscillateur devient sensible à la moindre variation de la tension de commande, et son bruit de phase se trouve lui-même augmenté de façon importante, car amplifié par un gain élevé.

De plus, si ce gain n'est pas constant, l'oscillateur devient difficilement utilisable dans une boucle à verrouillage de phase en raison des problèmes de variation de bande passante rencontrés, pouvant conduire à une augmentation considérable du bruit intégré, à une dégradation de stabilité de la boucle, et corrélativement à une augmentation inacceptable du temps d'établissement d'une boucle à verrouillage de phase.

L'invention vise à surmonter ces difficultés en proposant un oscillateur commandé en tension présentant un gain de transfert réduit sans réduction de la plage de fréquences accessibles.

A cette fin, l'oscillateur de l'invention, par ailleurs conforme à la définition générique qu'en donne le préambule ci-dessus, est essentiellement caractérisé en ce que le circuit capacitif comprend un ensemble de branches incluant, en plus de la première branche, au moins une seconde branche du même type, en ce que les différentes branches de l'ensemble sont montées en parallèle entre les première et seconde bornes principales, en ce que la tension de commande est appliquée à la borne centrale de chaque branche de l'ensemble, et en ce que les bornes extrêmes des différentes branches sont polarisées par des tensions de polarisation qui diffèrent d'une branche à l'autre.

Dans le cas où le circuit capacitif comprend au moins trois branches du même type, les tensions de polarisation appliquées aux bornes extrêmes des différentes branches peuvent être étagées, par exemple de façon régulière.

Dans un mode de réalisation possible de l'oscillateur de l'invention, les différentes branches de l'ensemble comprennent des nombres différents d'éléments capacitifs.

L'oscillateur de l'invention peut notamment être réalisé en prévoyant que les éléments capacitifs à capacité variable soient constitués par des varactors de type MOS (Métal-oxyde-Semiconducteur), et en appliquant chaque tension de polarisation à travers une résistance.

Enfin, les bornes extrêmes de chaque branche sont de préférence respectivement reliées aux première et seconde bornes principales à travers des première et seconde capacités de découplage respectives.

D'autres caractéristiques et avantages de l'invention ressortiront clairement de la description qui en est faite ci-après, à titre indicatif et nullement limitatif, en référence aux dessins annexés, dans lesquels :

- la figure 1 est un schéma représentant, de façon générique, un oscillateur commandé en tension par variation de capacité de son circuit capacitif, du type auquel appartient l'oscillateur de l'invention ;

- la figure 2 est un diagramme représentant, en unités arbitraires, les valeurs Y que prennent la capacité et la sensibilité d'un varactor en fonction de la différence entre sa tension de polarisation et sa tension de commande ;

- la figure 3 est un schéma représentant un circuit capacitif de type connu pour la réalisation d'un oscillateur commandé en tension de façon différentielle ;

- la figure 4 est un diagramme représentant, en unités arbitraires, la capacité Cb que présente le circuit de la figure 3 dans le cas où ce circuit ne comprend que deux varactors, et la capacité CT que présente le circuit capacitif CAPA de la figure 1 dans le cas où ce circuit est constitué par un circuit conforme à celui de la figure 3 et utilisant huit varactors ;

- la figure 5 est un schéma représentant un circuit capacitif pour la réalisation d'un oscillateur commandé en tension de façon différentielle et conforme à l'invention ; et

- la figure 6 est un diagramme représentant, en unités arbitraires, la capacité Cb que présente chaque branche d'un circuit capacitif CAPA à quatre branches et huit varactors ayant une structure telle qu'illustrée à la figure 5, et la capacité totale CT que présente ce même circuit capacitif CAPA à quatre branches et huit varactors.

Comme annoncé précédemment, l'invention concerne un oscillateur commandé en tension essentiellement formé d'un circuit oscillant OSCILL et d'un circuit actif ACT.
Le circuit oscillant OSCILL comprend lui-même un circuit inductif INDUC et un circuit capacitif CAPA montés en parallèle l'un par rapport à l'autre entre deux bornes principales K1 et K2.
Le circuit actif ACT, qui est branché aux bornes K1 et K2, a pour rôle d'apporter l'énergie électrique nécessaire à l'entretien d'un transfert oscillant d'énergie électrique entre les circuits inductif INDUC et capacitif CAPA, ce transfert d'énergie présentant une fréquence d'oscillation F qui varie en fonction de la capacité CT du circuit capacitif CAPA.

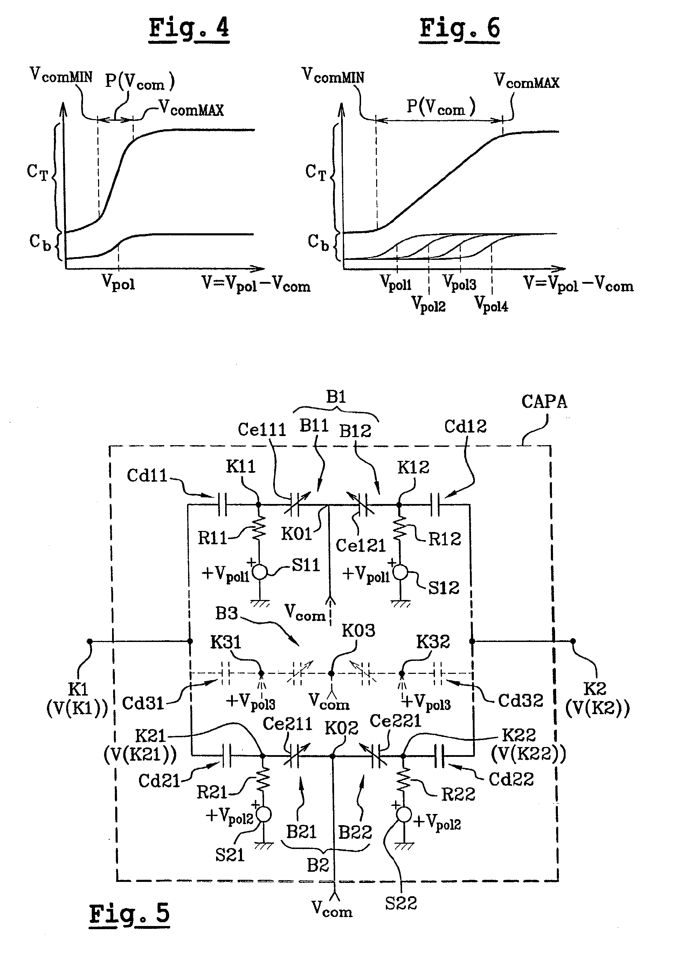

La figure 3 illustre un circuit capacitif CAPA connu, ce circuit étant constitué par une branche unique B1 comprenant des éléments capacitifs à capacité Co(V) variable, tels que des varactors Ce111 et Ce121, montés en série entre les bornes principales K1 et K2.
Ces varactors, qui sont en nombre pair, sont répartis sur les deux moitiés B11 et B12 de la branche B1, qui sont symétriques l'une de l'autre par rapport à une borne centrale K01 sur laquelle est appliquée une tension de commande Vcom.
La branche B1 présente, sur ses moitiés respectives B11 et B12, des bornes extrêmes K11 et K12 respectivement reliées aux bornes principales K1 et K2 à travers des capacités de découplage respectives Cd11 et Cd12.
Les capacités de découplage Cd11 et Cd12 forment, avec les varactors Ce111 et Ce121, et entre la borne centrale K01 et les bornes extrêmes K11 et K12, des diviseurs capacitifs respectifs grâce auxquels les potentiels VK11 et VK12 des bornes extrêmes K11 et K12 ont des amplitudes réduites, respectivement liées à celles des potentiels VK1 et VK2 des bornes principales K1 et K2 par des coefficients de proportionnalité. identiques, bien que variables en fonction de la capacité des varactors Ce111 et Ce121.
Les moitiés B11 et B12 de la branche B1 comportent en outre des sources de tension respectives S11 et S12, appliquant une tension de polarisation Vpol aux bornes extrêmes respectives K11 et K12 de cette branche par l'intermédiaire d'inductances de polarisation correspondantes L11 et L12.
Les potentiels VK11 et VK12 des bornes extrêmes K11 et K12 sont ainsi respectivement proportionnels aux potentiels VK1 et VK2 des bornes principales, et décalés par rapport à ceux-ci de la valeur de la tension de polarisation Vpol.
Dans ces conditions, la capacité totale CT de la branche B1 varie en fonction de la différence V= Vpol-Vcom entre la tension de polarisation Vpol et la tension de commande réglable Vcom.
La figure 2 montre l'évolution, en fonction de cette différence V=Vpol-Vcom, de la capacité Co(V) et de la sensibilité S d'un varactor, la sensibilité S étant définie en fonction de la différence de potentiel V par :

$$S(V) = d(C) / d(V).$$

En fait, bien que la figure 3 ne représente que deux varactors, il est en pratique souvent utile de monter plusieurs varactors en parallèle sur chaque moitié de la branche B1 pour pouvoir couvrir toute la plage de fréquence réglable désirée.
Plus cette plage est grande, et plus le nombre de varactors employés est donc élevé.
Certaines technologies ne permettent de disposer que de varactors présentant des caractéristiques de fonctionnement abruptes, donc une sensibilité élevée et fortement non linéaire, conduisant pour l'oscillateur à un bruit de phase important.
Or, plus le nombre de varactors unitaires est élevé, et plus grande est la sensibilité totale du circuit capacitif CAPA.
Cette relation est illustrée par la figure 4, sur laquelle Cb est la capacité du circuit de la figure 3 dans le cas où ce circuit ne comprend que deux varactors, et sur laquelle CT est la capacité du circuit capacitif CAPA

**EP 1 406 379 A1**

de la figure 1, dans le cas où ce circuit a la structure de celui de la figure 3 mais utilise huit varactors.

Comme le montre cette figure, la plage P (Vcom), sur laquelle la tension de commande Vcom peut être choisie entre sa valeur minimale VcomMin et sa valeur maximale VcomMAX, est ainsi très étroite.

Comme la commande de fréquence est représentée par la différence de potentiels V=Vpol-Vcom, la stabilité de cette différence est d'autant plus importante que la sensibilité totale du circuit capacitif CAPA est élevée.

Dans un tel cas, en effet, une variation de quelques millivolts de la tension de commande peut faire varier la fréquence F de plusieurs mégahertz.

Or, il est justement très difficile de réaliser des références de tensions intégrées peu bruyantes, aussi bien pour la tension de polarisation que pour la tension de commande.

La solution proposée par l'invention consiste, schématiquement, à répartir la sensibilité de l'ensemble des varactors sur une plus grande plage de tension de commande.

Pour ce faire, le circuit capacitif CAPA, au lieu de ne comprendre qu'une seule branche B1, comprend en fait un ensemble de plusieurs branches du même type, telles que B1, B2, et B3, qui sont montées en parallèle les unes par rapport aux autres entre les bornes principales K1 et K2.

Par ailleurs, la tension de commande Vcom est appliquée à la borne centrale, telle que K01, K02, et K03 de chacune des branches B1, B2, et B3 de l'ensemble, alors que les bornes extrêmes telles que K11, K12, K21, K22, K31, et K32 de ces différentes branches sont polarisées par des tensions de polarisation, telles que Vpo11, Vpol2, et Vpol3, qui diffèrent d'une branche à l'autre.

Les varactors de chaque branche travaillent ainsi, pour une même tension de commande Vcom, dans une zone de leur caractéristique Co(V) qui est spécifique à cette branche, les différentes zones exploitées étant décalées les unes par rapport aux autres sur les différentes branches.

Ce mode opératoire et ses effets sont illustrés par la figure 6, sur laquelle Cb est la capacité de chaque branche d'un circuit capacitif CAPA à quatre branches et à huit varactors ayant une structure telle qu'illustrée à la figure 5, c'est-à-dire conforme à l'enseignement de l'invention, et dans laquelle CT est la capacité totale que présente ce même circuit capacitif CAPA à quatre branches et à huit varactors.

Comme le montre cette figure, la plage P (Vcom), sur laquelle la tension de commande Vcom peut être choisie entre sa valeur minimale VcomMin et sa valeur maximale VcomMAX, est alors bien plus large que dans le cas de l'art antérieur, illustré à la figure 4.

Dans le cas où le circuit capacitif CAPA comprend trois branches ou plus du même type, telles que les branches B1, B2, et B3, les tensions de polarisation Vpol1, Vpol2, Vpol3 appliquées aux bornes extrêmes telles que K11, K12, K21, K22, K31, et K32 de ces différentes branches sont par exemple étagées de façon régulière.

Dans ce cas, l'égalité Vpol3 - Vpol2 = Vpo12 - Vpo11 est alors vérifiée dans le cas de trois branches, et les égalités Vpol4 - Vpol3 = Vpol3 - Vpol2 = Vpol2 - Vpol1 sont vérifiées dans le cas de quatre branches, comme le montre la figure 6.

Néanmoins, il est également possible de prévoir que les écarts entre les couples successifs de tensions de polarisation soient différents les uns des autres pour permettre un ajustement de la sensibilité S(V).

Par ailleurs, il est possible de donner au circuit capacitif CAPA une structure dans laquelle les différentes branches telles que B1 à B3 comprennent des nombres différents de varactors, chaque demi-branche pouvant comprendre plusieurs varactors en parallèle.

L'invention est particulièrement bien adaptée et efficace dans le cas où les varactors utilisés sont du type Métal-Oxyde-Semiconducteur (MOS).

L'invention présente de nombreux avantages.

Tout d'abord, la plage P(Vcom) de la tension de commande utilisable pour contrôler la fréquence étant plus grande, et le gain de transfert de l'oscillateur étant corrélativement plus faible, cet oscillateur peut être asservi par une boucle à verrouillage de phase. Les problèmes de bande passante sont fortement atténués, le bruit intégré est nettement réduit, et le temps d'établissement est sensiblement raccourci.

Le gain de transfert de l'oscillateur étant constant et réduit, le bruit de phase de l'oscillateur est moins sensible au bruit généré par l'électronique de polarisation.

Il n'est dès lors plus nécessaire d'employer des inductances de polarisation et de découplage, chacune des tensions de polarisation telle que Vpol1, Vpol2, et Vpol3 pouvant être appliquée à travers une simple résistance telle que R11, R12, R21, et R22.

Dans la mesure où les inductances de polarisation utilisées dans l'art antérieur étaient de qualité moyenne compte tenu de leur coût et donc elles-mêmes génératrices de bruits, mais néanmoins relativement encombrantes, la suppression de ces inductances apporte à la fois un gain de place, une économie non négligeable, et une réduction supplémentaire du bruit.

Grâce à l'invention, le bruit de phase de l'oscillateur est constant sur toute la bande des fréquences couverte dans la mesure où la contribution de la polarisation sur le bruit est constante, et non plus fortement amplifiée autour de la tension de polarisation.

L'invention rend possible, moyennant un recalcul de l'ensemble des capacités de l'oscillateur, accessible à l'homme de métier sur la base de la description ci-dessus, de réduire le nombre de varactors utilisés, et d'atténuer ainsi les phénomènes non linéaires liés au fonctionnement de ces varactors, cette mesure ayant elle-même un effet favorable sur la réduction du bruit de phase de l'oscillateur.

## Revendications

1. Oscillateur commandé en tension, comprenant un circuit oscillant (OSCILL) et un circuit actif (ACT), le circuit oscillant (OSCILL) comprenant lui-même un circuit inductif (INDUC) et un circuit capacitif (CAPA) partageant des première et seconde bornes principales (K1, K2) auxquelles le circuit actif (ACT) est relié pour entretenir un transfert oscillant d'énergie électrique entre les circuits inductif (INDUC) et capacitif (CAPA) à une fréquence (F) dépendant de la capacité (CT) du circuit capacitif (CAPA), cette capacité (CT) variant en fonction d'une différence de potentiel réglable (Vpol-Vcom) formée par différence entre une tension de polarisation (Vpol) et une tension de commande réglable (Vcom), le circuit capacitif (CAPA) comprenant une première branche (B1) du type de celles dont chacune comprend des éléments capacitifs (Ce111, Ce121) à capacité (Co) variable montés en série entre les première et seconde bornes principales (K1, K2) et répartis sur des première et seconde moitiés (B11, B12) de cette branche (B1), symétriques l'une de l'autre par rapport à une borne centrale (K01) sur laquelle est appliquée la tension de commande (Vcom), ces première et seconde moitiés (B11, B12) de branche présentant respectivement des première et seconde bornes extrêmes (K11, K12) portées à des premier et second potentiels respectifs (V(K11), V(K12)), respectivement proportionnels aux potentiels (V(K1), V(K2)) des première et seconde bornes principales et décalés par la tension de polarisation (Vpol), **caractérisé en ce que** le circuit capacitif (CAPA) comprend un ensemble de branches (B1, B2, B3) incluant, en plus de la première branche (B1), au moins une seconde branche (B2) du même type, **en ce que** les différentes branches (B1, B2, B3) de l'ensemble sont montées en parallèle entre les première et seconde bornes principales (K1, K2), **en ce que** la tension de commande (Vcom) est appliquée à la borne centrale (K01, K02, K03) de chaque branche (B1, B2, B3) de l'ensemble, et **en ce que** les bornes extrêmes (K11, K12; K21, K22; K31, K32) des différentes branches (B1, B2, B3) sont polarisées par des tensions de polarisation (Vpol1, Vpol2, Vpol3) qui diffèrent d'une branche (B1, B2, B3) à l'autre.

2. Oscillateur suivant la revendication 1, **caractérisé en ce que** le circuit capacitif (CAPA) comprend au moins trois branches (B1, B2, B3) du même type.

3. Oscillateur suivant la revendication 2, **caractérisé en ce que** les tensions de polarisation (Vpol1, Vpol2, Vpol3) appliquées aux bornes extrêmes (K11, K12; K21, K22; K31, K32) des différentes branches (B1, B2, B3) sont étagées de façon régulière.

4. Oscillateur suivant l'une quelconque des revendications précédentes, **caractérisé en ce que** les différentes branches (B1, B2, B3) de l'ensemble comprennent des nombres différents d'éléments capacitifs (Ce111, Ce121; Ce211, Ce221).

5. Oscillateur suivant l'une quelconque des revendications précédentes, **caractérisé en ce que** les éléments capacitifs (Ce111) à capacité variable sont constitués par des varactors de type MOS (Métal-Oxyde-Semiconducteur).

6. Oscillateur suivant l'une quelconque des revendications précédentes, **caractérisé en ce que** chaque tension de polarisation (Vpol1, Vpol2, Vpol3) est appliquée à travers une résistance (R11, R12, R21, R22).

7. Oscillateur suivant l'une quelconque des revendications précédentes, **caractérisé en ce que** les bornes extrêmes (K11, K12; K21, K22; K31, K32) de chaque branche sont respectivement reliées aux première et seconde bornes principales (K1, K2) à travers des première et seconde capacités de découplage respectives (Cd11, Cd12; Cd21, Cd22; Cd31, Cd32).

**Fig. 1**

OSCILL

INDUC    CAPA    K2

ACT

K1

V_com

**Fig. 2**

S(v)    C_0(v)

$V_{pol} - V_{com}$

**Fig. 3**

B1
B11  B12    CAPA

Cd11    K11
(V(K11))    K12
(V(K12))    Cd12

K1
(V(K1))    +V_pol    L11    K01    +V_pol    L12    K2
(V(K2))

S11    Ce111    Ce121    S12

V_com

6

## Fig. 4

## Fig. 6

## Fig. 5

**Office européen des brevets**

**RAPPORT DE RECHERCHE EUROPEENNE**

Numéro de la demande

EP 03 29 2240

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 2002/008593 A1 (GOMEZ RAMON ALEJANDRO ET AL) 24 janvier 2002 (2002-01-24) * le document en entier * --- | 1-7 | H03B5/12 |
| A | US 4 503 402 A (ENGLUND JR ARVID E) 5 mars 1985 (1985-03-05) * abrégé; figure 2 * --- | 1-7 | |
| A | US 4 801 898 A (OBAYASHI KATSUKI) 31 janvier 1989 (1989-01-31) * abrégé; figure 1 * ----- | 1-7 | |

|  |  |  | DOMAINES TECHNIQUES RECHERCHES (Int.Cl.7) |
|---|---|---|---|
|  |  |  | H03B H03J |

Le présent rapport a été établi pour toutes les revendications

| Lieu de la recherche | Date d'achèvement de la recherche | Examinateur |
|---|---|---|
| LA HAYE | 7 novembre 2003 | Beasley-Suffolk, D |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 03 29 2240

La présente annexe indique les membres de la famille de brevets relatifs aux documents brevets cités dans le rapport de recherche européenne visé ci-dessus.

Lesdits members sont contenus au fichier informatique de l'Office européen des brevets à la date du

Les renseignements fournis sont donnés à titre indicatif et n'engagent pas la responsabilité de l'Office européen des brevets.

07-11-2003

| Document brevet cité au rapport de recherche | | Date de publication | Membre(s) de la famille de brevet(s) | | Date de publication |
|---|---|---|---|---|---|
| US 2002008593 | A1 | 24-01-2002 | US<br>AU<br>EP<br>WO | 2003164743 A1<br>2580601 A<br>1247331 A1<br>0145251 A1 | 04-09-2003<br>25-06-2001<br>09-10-2002<br>21-06-2001 |
| US 4503402 | A | 05-03-1985 | JP | 59063806 A | 11-04-1984 |
| US 4801898 | A | 31-01-1989 | AUCUN | | |

EPO FORM P0460